# EUROPEAN PATENT APPLICATION

(11) **EP 1 460 626 A1**
(43) Date of publication of application: **22.09.2004**
(21) Application number: 02790950.6
(22) Date of filing: 27.12.2002
(51) Int. Cl.: G11B 7/26

(54) **METHOD FOR MANUFACTURING STAMPER FOR INFORMATION MEDIUM MANUFACTURE, STAMPER, AND PHOTORESIST ORIGINAL DISK**

(30) Priority: 28.12.2001 JP 2001398994
(71) Applicant: TDK Corporation, Chuo-ku, Tokyo 103-8272 (JP)
(72) Inventor: OYAKE, Hisaji, c/o TDK CORPORATION, Tokyo 103-8272 (JP); TAKAHATA, Hiroaki, c/o TDK CORPORATION, Tokyo 103-8272 (JP); ARAI, Hitoshi, c/o TDK CORPORATION, Tokyo 103-8272 (JP); UTSUNOMIYA, Hajime, c/o TDK CORPORATION, Tokyo 103-8272 (JP)
(74) Representative: Geyer, Ulrich F., Dr. Dipl.-Phys.
(86) International application number: PCT/JP2002/013876
(87) International publication number: WO 2003/058613

(57) **Abstract**

A stamper with a.sharp protrusion/depression pattern is obtained, and high precision information media can be produced using this stamper.

A method of manufacturing a stamper comprises the steps of manufacturing a photoresist master 100 by laminating a light absorption layer 103 and a photoresist layer 104 on top of a substrate 102, and then forming an protrusion/depression pattern 106 in the photoresist layer 104 by forming and developing a latent image, providing Pd on the surface of the protrusion/depression pattern 106 as a preliminary treatment to conducting electroless plating onto the protrusion/depression pattern of the photoresist master 100, and forming a stamper 120 by forming a thin metal film 108 on top of the Pd-containing protrusion/depression pattern surface by using electroless plating, forming a Ni film 110 on top of this Ni thin film 108 using electroforming, and then removing the thin metal film 108 and the Ni film 110.

## Description

### TECHNICAL FIELD

The present invention relates to a stamper used during the manufacture of an information medium having an protrusion/depression pattern such as grooves and prepits, a photoresist master for manufacturing the stamper, a method of manufacturing the stamper using the photoresist master, and an information medium manufactured by the stamper.

### BACKGROUND ART

Optical discs, which represent one type of information media, are currently available in two different varieties: optical recording discs which enable writing or rewriting of information, and read-only discs in which the information has been pre-recorded onto the disc.

A groove (guide channel) that is used for tracking and the like is formed in the disc substrate of an optical recording disc, and a recording layer comprising a phase change material or an organic dye material is laminated on top of the disc substrate. When the laser beam is irradiated onto the recording layer, the recording layer undergoes a chemical or physical change, thus forming a recording mark. In contrast, in the case of a read-only disc, recording marks (information pits) are formed in advance as part of an protrusion/depression pattern on the disc substrate. When a reading laser beam is irradiated onto these recording marks, the quantity of reflected light varies, and by detecting these variations, the information can be read (played back).

In order to manufacture a disc substrate with an protrusion/depression pattern of grooves, information pits, and the like, a stamper is used in which the negative pattern (which is itself a type of protrusion/depression pattern) of the desired protrusion/depression pattern has been formed. For example, a method of manufacturing a disc substrate by conducting injection molding using a mold with the above stamper secured inside the cavity, thereby transferring the negative pattern to the resin used to fill the cavity, is common.

A stamper with an protrusion/depression pattern is usually formed from a metal stamper containing Ni or the like. In the steps required for manufacturing this stamper, first a photoresist master with the negative pattern of the protrusion/depression pattern of the stamper is prepared, and a metal film is then formed on this photoresist master by plating. Subsequently, the metal film is separated from the photoresist master, and then subjected to a series of predetermined treatments such as surface washing to form the stamper.

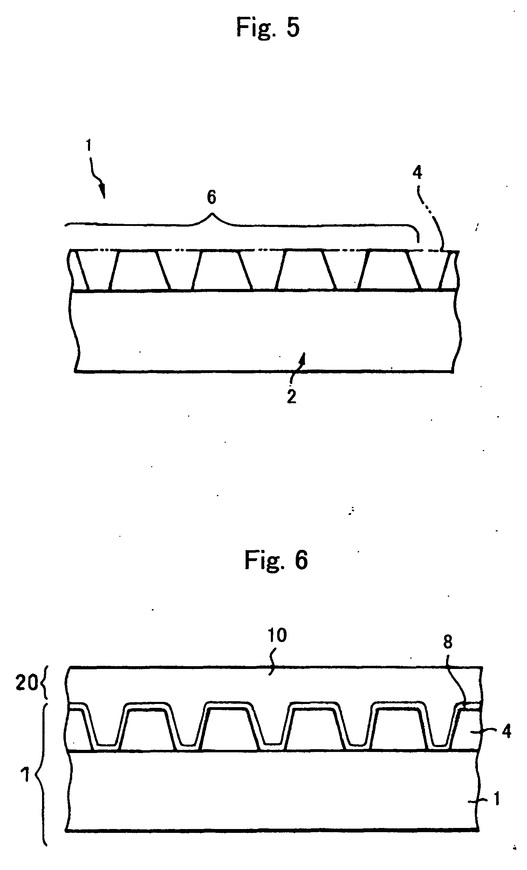

As follows is a description of the manufacturing process for a photoresist master 1, with reference to the conventional photoresist master 1 shown in Fig. 5. First, a photoresist layer 4 is formed on top of a glass substrate 2. Next, the photoresist layer 4 is exposed using a patterning laser beam such as a laser, and the latent image pattern is developed. This enables the production of the photoresist master 1 with an protrusion/depression pattern 6 formed in the photoresist layer 4.

In order to use this photoresist master 1 to prepare a stamper 20 by plating, first, as shown in Fig. 6, a thin metal film 8 containing a Ni material or the like is formed on the surface of the protrusion/depression pattern 6 using a process such as electroless plating, thereby imparting conductivity to the photoresist master 1.

Subsequently, electroplating is conducted with the thin metal film 8 as a backing, thereby forming a metal film 10 containing Ni or the like. By removing the thin metal film 8 and the metal film 10 from the photoresist master 1, a stamper 20 containing the transferred protrusion/depression pattern 6 can be obtained.

In recent years, as the capacity of optical recording media has increased, protrusion/depression patterns such as grooves have become much finer, meaning errors in the pattern shape have a large effect on the recording and reading accuracy. Accordingly, it is desirable to form a sharp protrusion/depression pattern on the disc substrate, but in order to achieve this sharp pattern, the protrusion/depression pattern of the photoresist layer 4, which is the basis for the pattern, must be formed with a high level of precision (sharpness).

The minimum width of the latent image pattern formed on the photoresist layer 4 is limited by the spot diameter of the laser beam when it reaches the photoresist layer 4. When λ is the laser wavelength, and NA is the numerical aperture of the objective lens of the irradiating optical system, then the spot diameter w is represented by the formula w = k·λ/NA. k is a constant that is determined by the aperture shape of the objective lens and the intensity distribution of the incident light beam.

However, even in the case of patterns with widths that theoretically do not exceed the spot diameter limit, if the photoresist layer 4 is thin, then problems of inadequate sharpness can arise due to factors such as shallowness of the protrusion/depression pattern transferred to the stamper, or rounding of the shape of the protrusion/depression pattern (this is known as pattern sag). It is thought that these problems are caused by fluctuations occurring in the thickness of the photoresist layer 4 (this is known as film thinning) during typical exposure and developing operations. It is thought that these thickness fluctuations are caused by laser beam reflection between the photoresist layer 4 and the glass substrate 2, with this reflection causing excessive exposure of the photoresist layer 4.

### DISCLOSURE OF THE INVENTION

The present invention is directed to a solution to the above described disadvantage, and it is an object of the present invention to provide a method of manufacturing a photoresist master which enables the formation of sharp patterns with widths that are even narrower than the spot diameter of the laser beam, as well as a photoresist master, and a stamper manufactured using such a photoresist master.

As a result of intensive research on optical recording media and methods of manufacturing information media such as magnetic discs (discrete media), the inventor of the present invention discovered a method of forming a sharp protrusion/depression pattern on a stamper. In other words, the above object can be achieved by the invention described below.
(1) A method of manufacturing a stamper for manufacturing an information medium, comprising the steps of: manufacturing a photoresist master by forming at least a light absorption layer and a photoresist layer, in that order, on top of a substrate, irradiating light onto said photoresist layer from an opposite surface to that which contacts said light absorption layer to form a latent image, and then developing this latent image to form an protrusion/depression pattern; forming a thin metal film on top of said protrusion/depression pattern of said photoresist master; forming a stamper by forming a metal film on top of said thin metal film, and separating said thin metal film and said metal film from said photoresist master; and providing Pd on a surface of said protrusion/depression pattern as a preliminary treatment to the step of forming said thin metal film on said photoresist layer.
(2) The method of manufacturing a stamper for manufacturing an information medium according to (1), wherein in said step for providing Pd, a quantity Y of Pd provided on a mirror surface, which represents an area in which said protrusion/depression pattern is not formed, relative to a quantity X of Pd provided on a pattern surface, which represents an area in which protrusion/depressionnesses are formed by said protrusion/depression pattern, satisfies 0.9X < Y < 1.1X.
(3) A stamper for manufacturing an information medium, in a surface of the stamper an protrusion/depression pattern being formed in advance, the stamper being manufactured by the steps of: manufacturing a photoresist master by forming at least a light absorption layer and a photoresist layer, in that order, on top of a substrate, irradiating light onto said photoresist layer from an opposite surface to that which contacts said light absorption layer to form a latent image, and then developing this latent image to form an protrusion/depression pattern; forming a thin metal film on top of said protrusion/depression pattern of said photoresist master; forming the stamper by forming a metal film on top of said thin metal film, and separating said thin metal film and said metal film from said photoresist master; and providing Pd on a surface of said protrusion/depression pattern as a preliminary treatment to the step of forming said thin metal film on said photoresist layer.
(4) A photoresist master comprising a substrate, a light absorption layer laminated on top of said substrate, and a photoresist layer which is laminated on top of said light absorption layer and is capable of having an protrusion/depression pattern formed therein by forming and subsequently developing of a latent image, wherein Pd is provided on a surface of said protrusion/depression pattern formed in said photoresist layer.
(5) A stamper for manufacturing an information medium, manufactured from a photoresist master having a substrate, a light absorption layer laminated on top of said substrate, and a photoresist layer which is laminated on top of said light absorption layer and is capable of having an protrusion/depression pattern formed therein by forming and subsequently developing of a latent image, and in which Pd is provided on a surface of said protrusion/depression pattern formed in said photoresist layer, wherein a quantity Y of Pd provided on a mirror surface, which represents an area in which said protrusion/depression pattern is not formed, relative to a quantity X of Pd provided on a pattern surface, which represents an area in which protrusion/depressionnesses are formed by said protrusion/depression pattern, satisfies 0.9X < Y < 1.1X.
(6) An information medium, in which a final protrusion/depression pattern is formed by using, as a negative pattern, an protrusion/depression pattern of a stamper manufactured by the steps of: manufacturing a photoresist master by forming at least a light absorption layer and a photoresist layer, in that order, on top of a substrate, irradiating light onto said photoresist layer from an opposite surface to that which contacts said light absorption layer to form a latent image, and then developing said latent image to form an protrusion/depression pattern; forming a thin metal film on top of said protrusion/depression pattern of said photoresist master; forming a stamper by forming a metal film on top of said thin metal film, and separating said thin metal film and said metal film from said photoresist master; and providing Pd on a surface of said protrusion/depression pattern as a preliminary treatment to the step of forming said metal thin film on said photoresist layer.
(7) The information medium according to (6), wherein
   said final protrusion/depression pattern is formed by direct transfer of said protrusion/depression pattern from said stamper.
(8) The information medium according to (6), wherein
   said final protrusion/depression pattern is formed by transfer of an protrusion/depression pattern from a mother stamper, which has been formed by transfer of said protrusion/depression pattern using said stamper as a master stamper.
(9) The information medium according to (6), wherein
   said final protrusion/depression pattern is formed by transfer of an protrusion/depression pattern from a child stamper, and said protrusion/depression pattern of said child stamper is formed by transfer of an protrusion/depression pattern from a mother stamper, which has been formed by transfer of said protrusion/depression pattern using said stamper as a master stamper.
(10) An information medium, in which a final protrusion/depression pattern is formed by using, as a negative pattern, an protrusion/depression pattern of a stamper which is manufactured from a photoresist master having a substrate, a light absorption layer laminated on top of said substrate, and a photoresist layer which is laminated on top of said light absorption layer and is capable of having an protrusion/depression pattern formed therein by forming and subsequently developing of a latent image, and in which Pd is provided on a surface of said protrusion/depression pattern formed in said photoresist layer, wherein a quantity Y of Pd provided on a mirror surface, which represents an area in which said protrusion/depression pattern is not formed, relative to a quantity X of Pd provided on a pattern surface, which represents an area in which protrusion/depressionnesses are formed by said protrusion/depression pattern, satisfies 0.9X < Y < 1.1X.
(11) The information medium according to (10), wherein
   said final protrusion/depression pattern is formed by direct transfer of said protrusion/depression pattern from said stamper.
(12) The information medium according to (10), wherein
   said final protrusion/depression pattern is formed by transfer of an protrusion/depression pattern from a mother stamper, which has been formed by transfer of said protrusion/depression pattern using said stamper as a master stamper.
(13) The information medium according to (10), wherein
   said final protrusion/depression pattern is formed by transfer of an protrusion/depression pattern from a child stamper, and said protrusion/depression pattern of said child stamper is formed by transfer of an protrusion/depression pattern from a mother stamper, which has been formed by transfer of said protrusion/depression pattern using said stamper as a master stamper.

The inventor of the present invention confirmed that by using a light absorption layer, and also providing Pd in the photoresist master, a sharp protrusion/depression pattern could be formed on a stamper. It is thought that the reason for this finding is that the Pd affinity of the light absorption layer is extremely close to the Pd affinity of the photoresist layer, and that this Pd is consequently dispersed uniformly across the surface of the photoresist master. Consequently, the protrusion/depression pattern, which is exposed with good sharpness due to the characteristics of the light absorption layer, can be accurately reproduced on the thin metal film formed by electroless plating.

As a result, information media such as the grooves and information pits of an optical recording medium can also be formed with good sharpness, and this makes it possible to improve the recording and playback characteristics. Furthermore, because the invention is compatible with future ongoing miniaturization of protrusion/depression patterns, it also enables increases in the information memory (recording) capacity of information media.

### BRIEF DESCRIPTION OF THE DRAWINGS

Fig. 1 is a cross-sectional view showing a photoresist master according to an embodiment of the present invention;
Fig. 2(A) is a cross-sectional view showing a state during the manufacture of a stamper using the same photoresist master;
Fig. 2(B) is a cross-sectional view showing the manufactured stamper;
Fig. 3(A) is a diagram showing the result of an AFM analysis of the protrusion/depression pattern formed on a stamper according to an example of the present invention;
Fig. 3(B) is a line diagram showing the cross-sectional shape of the protrusion/depression pattern determined on the basis of the AFM analysis;
Fig. 4(A) is a diagram showing the result of an AFM analysis of the protrusion/depression pattern formed on a stamper according to a comparative example of the present invention;
Fig. 4(B) is a line diagram showing the cross-sectional shape of the protrusion/depression pattern determined on the basis of the AFM analysis;
Fig. 5 is a cross-sectional view showing a conventional photoresist master; and
Fig. 6 is a cross-sectional view showing a state during the manufacture of a stamper using the same conventional photoresist master.

### BEST MODE FOR CARRYING OUT THE INVENTION

As follows is a detailed description of an embodiment of the present invention, based on the drawings.

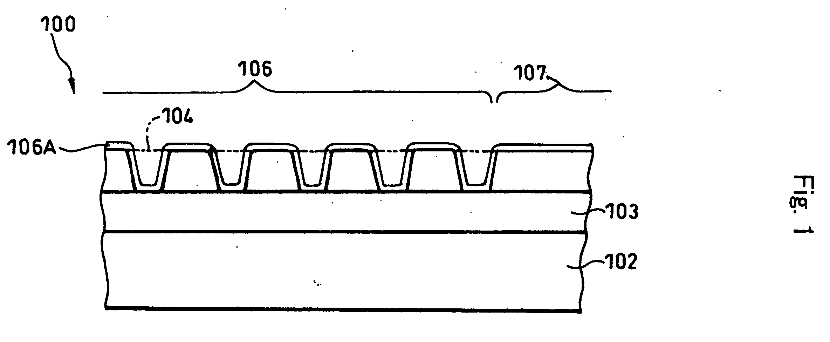

Fig. 1 shows a photoresist master 100 according to the embodiment of the present invention. This photoresist master 100 comprises a glass substrate 102, a light absorption layer 103 laminated on top of this glass substrate 102, and a photoresist layer 104 laminated on top of this light absorption layer 103. A latent image of an protrusion/depression pattern is formed on the photoresist layer 104, on the opposite side from the light absorption layer 103 (the top side in Fig. 1), by exposure with a patterning laser beam, and development of this latent image causes the removal of a portion of the photoresist layer, forming an protrusion/depression pattern 106. Following developing, portions of the light absorption layer 103 are exposed at the bottom surfaces of the concave sections of the protrusion/depression pattern 106. The numeral 107 in Fig. 1 shows a non-protrusion/depression area in which the protrusion/depression pattern has not been formed.

As described below, the aforementioned protrusion/depression pattern 106 becomes the pattern surface 206 of a stamper 120. Furthermore, the area in which the protrusion/depression pattern has not been formed becomes the mirror surface 207 of the stamper 120. During exposure, the patterning laser beam is absorbed by the light absorption layer 103, thereby suppressing light reflection and enabling the formation of fine protrusion/depressionnesses with good sharpness.

Pd (106A) is then provided on the surface of the protrusion/depression pattern 106 of the photoresist master 100. Specifically, a catalyst (a Pd-Sn compound) is adsorbed onto the surface of the protrusion/depression pattern 106, and an accelerator is used to remove only the Sn from the catalyst, leaving the Pd deposited on the surface of the protrusion/depression pattern 106.

In Fig. 1, the Pd (106A) is shown schematically as a thin film, but this does not represent the actual state of the Pd. In this embodiment, the quantities of Pd provided in the protrusion/depression pattern area 106 and the non-protrusion/depression area 107 are preferably set so that the deposition quantity Y of Pd on the mirror surface 207 of the stamper 120 relative to the deposition quantity X of Pd on the pattern surface 206 satisfies the equation 0.9X < Y < 1.1X.

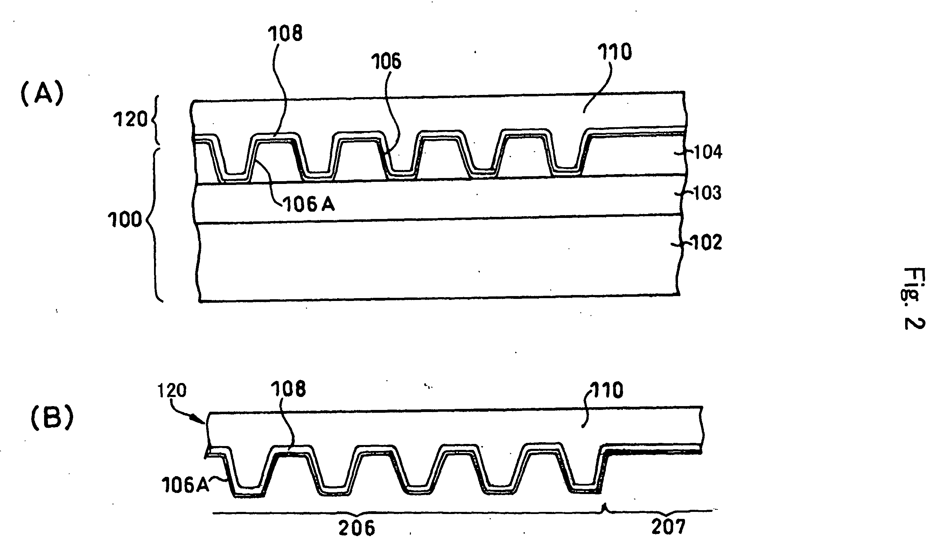

Fig. 2(A) shows the stamper 120 formed on top of the photoresist master 100.

In this formation process, first electroless plating is used to form a Ni thin film 108 on the surface of the protrusion/depression pattern 106 on which Pd has been deposited.

During this formation, a reducing agent in the plating solution is oxidized at the Pd surface, which possesses catalytic activity, and emits an electron, and this electron reduces a Ni ion in the solution, enabling the Ni thin film 108 to effectively conform to, and follow the protrusion/depression pattern 106. In this embodiment, adequate quantities of Pd are also provided on the bottom surfaces within the concave sections of the protrusion/depression pattern 106, meaning the Ni thin film 108 is formed in a manner that faithfully follows the protrusion/depression pattern 106.

Subsequently, a current is passed through the surface, using the Ni thin film 108 as a backing, and electroplating is carried out to form a Ni film 110. If the Ni thin film 108 and the Ni film 110 are then removed from the photoresist master 100, then as shown in Fig. 2(B), a stamper 120 comprising an accurately transferred protrusion/depression pattern 106 can be obtained. At this point, the aforementioned Pd (106A) remains bonded to the Ni thin film 108.

In this stamper 120, the pattern surface 206 is formed in the area corresponding with the protrusion/depression pattern 106, and the mirror surface 207 is formed corresponding with the non-protrusion/depression area 107.

Although not specifically shown in the drawings, the stamper 120 can then be installed in a mold, and injection molding or the like is used to manufacture an optical disc substrate having a final protrusion/depression pattern which is created by transferring the protrusion/depression pattern as a negative pattern. In addition to using the stamper 120 to manufacture optical disc substrates, the stamper 120 can also be used as a master stamper for preparing a mother stamper by an electroforming process, and this mother stamper can then be used to manufacture optical discs.

In addition, this mother stamper could also be used as a master for preparing a child stamper, and this child stamper can then be used to manufacture the optical discs. In other words, the stamper 120 of the present invention need not necessarily be used directly for the manufacture of optical discs, but may also be used indirectly for such optical disc manufacture, as the master stamper used in the preparation of a mother stamper or the like.

In the photoresist layer 104 of this embodiment, the provision of the light absorption layer 103 enables a well defined latent image to be projected, thus enabling a sharp protrusion/depression pattern 106 to be produced. In addition, because Pd is applied to the protrusion/depression pattern 106 as a preliminary treatment preceding the electroless plating, a precise Ni thin film 108 that conforms to the shape of the protrusion/depression pattern 106 can be formed.

It is surmised that one of the major reasons that the Ni thin film 108 can be formed with such good precision is that the Pd affinity of the exposed sections of the light absorption layer 103 within the concave sections of the protrusion/depression pattern 106 is favorable. This synergistic effect between the light absorption layer 103 and the applied Pd enables the sharp protrusion/depression pattern 106 to be transferred to the stamper 120 with good retention of this sharpness, and as a result, sagging of the protrusion/depression pattern formed on the stamper 120 is suppressed. By using this stamper 120, optical recording media with good levels of recording and reading (playback) accuracy can be produced.

Furthermore, even in those cases where exposure is stopped prior to exposure of the light absorption layer, that is, partway through the thickness of the photoresist layer, a synergistic effect is still obtained due to the applied Pd and the light absorption layer, and consequently the sharp protrusion/depression pattern can be transferred to the stamper with good retention of this sharpness, in a similar manner to that described above.

In addition, in the present embodiment only the case involving a Ni plating treatment was described, but the present invention is not limited to this case, and other metal plating can be used. Alternatively, the invention can also be applied to cases in which the thin metal film is formed by a process other than plating. In addition, the Ni film 110 may also be formed by a process other than electroplating.

Furthermore, the stamper described above is applicable not only to optical discs, but can also be applied generally to the manufacture of information media, including magnetic discs (discrete media).

### EXAMPLES

### (Example: Stamper No. 1)

Following formation of a layer of a coupling agent on top of a polished glass substrate, a light absorption layer was formed by spin coating. The application liquid used was SWK-T5D60 (manufactured by Tokyo Ohka Kogyo Co., Ltd.) containing 4,4'-bis(diethylamino)benzophenone as a light absorption agent. The applied layer was baked at 200°C for 15 minutes to cure the layer and remove residual solvent, thus forming a light absorption layer of 140 nm in thickness. Subsequently, a photoresist (DVR100, manufactured by Zeon Corporation) was spin coated onto the light absorption layer, and residual solvent was vaporized by baking, thus forming a photoresist layer of 25 nm in thickness.

Subsequently, using a cutting machine manufactured by Sony Corporation, and targeting the formation of a groove pattern with a track pitch of 320 nm and a groove width of 150 nm, the photoresist layer was exposed with a Kr laser (wavelength = 351 nm) and subsequently developed to form an protrusion/depression pattern, thus producing a photoresist master.

Following activation of the surface of the photoresist layer of this photoresist master using a surfactant, a catalyst (a Pd, Sn colloid) was applied as a preliminary treatment to electroless plating. An accelerator (HBF₄ solution) was then used to remove the Sn and achieve deposition of the Pd onto the photoresist surface, thus completing the preparation for electroless plating.

The photoresist master was then immersed in a NiCl₂ solution, and a Ni thin film was formed by electroless plating. Electroplating was then conducted with this Ni thin film as a backing, thus forming a Ni film. The laminate formed from this Ni thin film and the Ni film was separated from the master, the rear surface was polished, and the surface was washed, thus completing production of a stamper No. 1.

### (Comparative Example: Stamper No. 2)

With the exception of not providing a light absorption layer, a stamper No. 2 was prepared in the same manner as the preparation of the stamper No. 1.

### (Evaluation Results 1)

The shape of the protrusion/depression pattern formed on each stamper was confirmed by inspection using an AFM (atomic force microscope). A silicon nitride (SiN) probe tip was used for the AFM probe. Measurement was conducted using a noncontact mode, and the variations in atomic force between the sample and the probe were converted to an image.

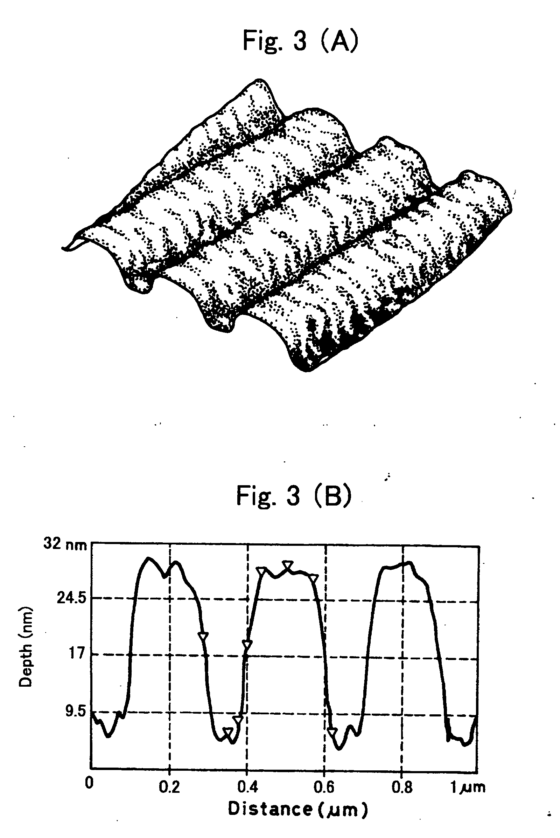

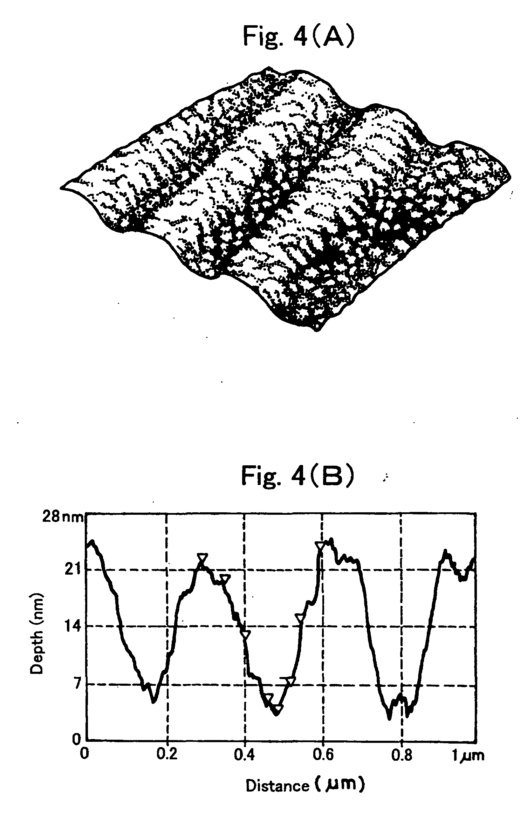

Fig. 3(A) shows the AFM image of the stamper No. 1, and Fig. 3(B) is a line diagram showing the cross-sectional shape of the same image. Similarly, Fig. 4(A) shows the AFM image of the stamper No. 2, and Fig. 4(B) is a line diagram showing the cross-sectional shape of the same image. In the AFM images, the dark areas of high dot density represent the concave sections within the protrusion/depression patterns, and the areas of low dot density or the white areas represent the convex sections, and these concave and convex sections correspond with the convex and concave sections respectively of the protrusion/depression pattern on the photoresist master. In Fig. 3(B) and Fig. 4(B), the protrusion/depression patterns are formed with a pitch of 0.32 µm.

As is evident from comparing Fig. 3 and Fig. 4, in the stamper No. 1 that was manufactured in accordance with the present invention, the effect of the light absorption layer resulted in the formation of a sharp pattern, and that pattern was transferred faithfully to the stamper.

### (Evaluation Results 2)

A Pd mass analysis of the pattern surface and the mirror surface for both the stamper No. 1 and the stamper No. 2 was conducted using ESCA (Electron Spectroscopy for Chemical Analysis). The results are shown in Table 1. Because the ESCA spot diameter is in the order of millimeters, the quantity of Pd within the pattern surface is the measurement result across a plurality of protrusion/depressionnesses.

**Table 1**

| |
|---|
| Results of Pd Mass Analyses |
| Stamper No. 1 |
| Pattern surface |
| Mirror Surface |

From Table 1 it is evident that in the stamper 1, which used a light absorption layer, a similar quantity of Pd was present in both the pattern surface and the mirror surface. In contrast in the stamper No. 2, the quantity of Pd in the pattern surface was much lower than that in the mirror surface. It is thought that this observation is due to the fact that in the case of the stamper No. 2, the bottom surfaces of the concave sections of the corresponding protrusion/depression pattern on the photoresist master expose the underlying glass surface.

### INDUSTRIAL APPLICABILITY

In the present invention, the light absorption layer contacting the photoresist layer enables the formation of a sharp protrusion/depression pattern on the photoresist master, and the Pd provided on the surface of this protrusion/depression pattern enables the production of a stamper that is faithful to this protrusion/depression pattern.

## Claims

1. A method of manufacturing a stamper for manufacturing an information medium, comprising the steps of:
manufacturing a photoresist master by forming at least a light absorption layer and a photoresist layer, in that order, on top of a substrate, irradiating light onto said photoresist layer from an opposite surface to that which contacts said light absorption layer to form a latent image, and then developing this latent image to form an protrusion/depression pattern;
forming a thin metal film on top of said protrusion/depression pattern of said photoresist master;
forming a stamper by forming a metal film on top of said thin metal film, and separating said thih metal film and said metal film from said photoresist master; and
providing Pd on a surface of said protrusion/depression pattern as a preliminary treatment to the step of forming said thin metal film on said photoresist layer.

2. The method of manufacturing a stamper for manufacturing an information medium according to claim 1, wherein
in said step for providing Pd, a quantity Y of Pd provided on a mirror surface, which represents an area in which said protrusion/depression pattern is not formed, relative to a quantity X of Pd provided on a pattern surface, which represents an area in which protrusion/depressionnesses are formed by said protrusion/depression pattern, satisfies 0.9X < Y < 1.1X.

3. A stamper for manufacturing an information medium, in a surface of the stamper an protrusion/depression pattern being formed in advance, the stamper being manufactured by the steps of: manufacturing a photoresist master by forming at least a light absorption layer and a photoresist layer, in that order, on top of a substrate, irradiating light onto said photoresist layer from an opposite surface to that which contacts said light absorption layer to form a latent image, and then developing this latent image to form an protrusion/depression pattern; forming a thin metal film on top of said protrusion/depression pattern of said photoresist master; forming the stamper by forming a metal film on top of said thin metal film, and separating said thin metal film and said metal film from said photoresist master; and providing Pd on a surface of said protrusion/depression pattern as a preliminary treatment to the step of forming said thin metal film on said photoresist layer.

4. A photoresist master comprising a substrate, a light absorption layer laminated on top of said substrate, and a photoresist layer which is laminated on top of said light absorption layer and is capable of having an protrusion/depression pattern formed therein by forming and subsequently developing of a latent image, wherein Pd is provided on a surface of said protrusion/depression pattern formed in said photoresist layer.

5. A stamper for manufacturing an information medium, manufactured from a photoresist master having a substrate, a light absorption layer laminated on top of said substrate, and a photoresist layer which is laminated on top of said light absorption layer and is capable of having an protrusion/depression pattern formed therein by forming and subsequently developing of a latent image, and in which Pd is provided on a surface of said protrusion/depression pattern formed in said photoresist layer, wherein a quantity Y of Pd provided on a mirror surface, which represents an area in which said protrusion/depression pattern is not formed, relative to a quantity X of Pd provided on a pattern surface, which represents an area in which protrusion/depressionnesses are formed by said protrusion/depression pattern, satisfies 0.9X < Y < 1.1X.

6. An information medium, in which a final protrusion/depression pattern is formed by using, as a negative pattern, an protrusion/depression pattern of a stamper manufactured by the steps of: manufacturing a photoresist master by forming at least a light absorption layer and a photoresist layer, in that order, on top of a substrate, irradiating light onto said photoresist layer from an opposite surface to that which contacts said light absorption layer to form a latent image, and then developing said latent image to form an protrusion/depression pattern; forming a thin metal film on top of said protrusion/depression pattern of said photoresist master; forming a stamper by forming a metal film on top of said thin metal film, and separating said thin metal film and said metal film from said photoresist master; and providing Pd on a surface of said protrusion/depression pattern as a preliminary treatment to the step of forming said metal thin film on said photoresist layer.

7. The information medium according to claim 6, wherein
said final protrusion/depression pattern is formed by direct transfer of said protrusion/depression pattern from said stamper.

8. The information medium according to claim 6, wherein
said final protrusion/depression pattern is formed by transfer of an protrusion/depression pattern from a mother stamper, which has been formed by transfer of said protrusion/depression pattern using said stamper as a master stamper.

9. The information medium according to claim 6, wherein
said final protrusion/depression pattern is formed by transfer of an protrusion/depression pattern from a child stamper, and said protrusion/depression pattern of said child stamper is formed by transfer of an protrusion/depression pattern from a mother stamper, which has been formed by transfer of said protrusion/depression pattern using said stamper as a master stamper.

10. An information medium, in which a final protrusion/depression pattern is formed by using, as a negative pattern, an protrusion/depression pattern of a stamper which is manufactured from a photoresist master having a substrate, a light absorption layer laminated on top of said substrate, and a photoresist layer which is laminated on top of said light absorption layer and is capable of having an protrusion/depression pattern formed therein by forming and subsequently developing of a latent image, and in which Pd is provided on a surface of said protrusion/depression pattern formed in said photoresist layer, wherein a quantity Y of Pd provided on a mirror surface, which represents an area in which said protrusion/depression pattern is not formed, relative to a quantity X of Pd provided on a pattern surface, which represents an area in which protrusion/depressionnesses are formed by said protrusion/depression pattern, satisfies 0.9X < Y < 1.1X.

11. The information medium according to claim 10, wherein
said final protrusion/depression pattern is formed by direct transfer of said protrusion/depression pattern from said stamper.

12. The information medium according to claim 10, wherein
said final protrusion/depression pattern is formed by transfer of an protrusion/depression pattern from a mother stamper, which has been formed by transfer of said protrusion/depression pattern using said stamper as a master stamper.

13. The information medium according to claim 10, wherein
said final protrusion/depression pattern is formed by transfer of an protrusion/depression pattern from a child stamper, and said protrusion/depression pattern of said child stamper is formed by transfer of an protrusion/depression pattern from a mother stamper, which has been formed by transfer of said protrusion/depression pattern using said stamper as a master stamper.
